# EUROPÄISCHE PATENTSCHRIFT

(11) **EP 3 841 856 B1**
(45) Veröffentlichungstag und Bekanntmachung des Hinweises auf die Patenterteilung: **23.08.2023**
(21) Anmeldenummer: 19753393.8
(22) Anmeldetag: 20.08.2019
(51) Int. Cl.: H05K 13/06, B25J 9/16, H01R 43/28, H02B 3/00

(54) **VERDRAHTUNGSROBOTER UND VERFAHREN ZUM VERDRAHTEN**
WIRING ROBOT AND METHOD OF WIRING
ROBOTS DE CÂBLAGE ET PROCÉDÉ DE CÂBLAGE

(30) Priorität: 22.08.2018 EP 18190291
(43) Veröffentlichungstag der Anmeldung: 30.06.2021
(73) Patentinhaber: W. Althaus AG, 4912 Aarwangen (CH)
(72) Erfinder: DEPRATO, Davor, 4616 Kappel (CH); ALTHAUS, Walter, 4912 Aarwangen (CH); CHELINI, Leandro Francesco, 8620 Wetzikon (CH); ROTACH, Toby Andreas, 8055 Zürich (CH)
(74) Vertreter: Hepp Wenger Ryffel AG
(86) Internationale Anmeldenummer: PCT/EP2019/072207
(87) Internationale Veröffentlichungsnummer: WO 2020/038912

(56) Entgegenhaltungen:
- DE-A1- 4 431 254
- DE-U1- 29 721 028
- DE-U1- 29 722 494
- System Robot Automazione: "Syndy, The independent solution", , 31. März 2012 (2012-03-31), Seiten 1-16, XP055539797, Visano, Italy Gefunden im Internet: URL:http://www.systemrobot.it/en/crlines/w iring-syndy [gefunden am 2019-01-09]
- M. BUSI ET AL: "The WIRES Experiment: Tools and Strategies for Robotized Switchgear Cabling", PROCEDIA MANUFACTURING, Bd. 11, 27. Juni 2017 (2017-06-27), Seiten 355-363, XP055539776, ISSN: 2351-9789, DOI: 10.1016/j.promfg.2017.07.118

## Beschreibung

Die vorliegende Erfindung betrifft einen Verdrahtungsroboter und ein Verfahren zum Verdrahten. Der Verdrahtungsroboter findet Anwendung z. B. beim Verdrahten von Montageplatten und Montagerahmen, von Schaltschränken und Schaltgerätekombinationen oder Teilen davon. Die Erfindung betrifft ebenfalls ein System und ein Verfahren zum Planen von Verdrahtungen und ein System und ein Verfahren zum Erfassen von Bauteilen gemäss dem Oberbegriff der unabhängigen Ansprüche.

Roboter sind aus der heutigen industriellen Produktion von Konsumgütern nicht mehr weg zu denken. Als erstes wurden einfache repetitive Arbeiten, wie das Bestücken von Maschinen oder das Entnehmen von Bauteilen automatisiert. Mit der Zeit wurden immer mehr Arbeitsschritte von Robotern übernommen, sodass heute nur noch bei sehr individualisierten Arbeiten der Mensch zum Zug kommt. Oft arbeiten kollaborative Robotersysteme bei individualisierten Arbeitsschritten Hand in Hand mit Menschen.

Zur Verdrahtung von elektrischen Bauteilen werden ebenfalls Roboter eingesetzt.

DE 297 22 494 U1 beschreibt eine Vorrichtung zum Verdrahten von Anschlussstellen von Komponenten elektrischer Geräte oder Anlagen.

DE 360 60 59 A1 beschreibt Werkzeuge zum Verlegen und Ablängen von Kabeln mit Hilfe eines Industrieroboters.

DE 443 12 54 A1 beschreibt ein Verfahren und eine Vorrichtung zur automatischen Verdrahtung von Komponenten elektrischer Geräte, z.B. von Fassungen, Vorschaltgeräten, Klemmen und dergleichen bei Leuchtstofflampen.

EP 0 917 259 B1 beschreibt ein Verfahren und eine Vorrichtung zum automatischen Verdrahten von Anschlussstellen von Komponenten elektrischer Geräte.

DE 443 85 25 A1 beschreibt ein Verfahren und eine Vorrichtung zur Bearbeitung und Verdrahtung von Schaltschränken und ihren Komponenten.

Alle in diesen Dokumenten beschriebenen Lösungen weisen die Nachteile auf, dass nur fix vorprogrammierte, standardisierte Arbeiten erledigt werden können.

DE 198 10 115 A1 beschreibt ein Verfahren zur Leitungsberechnung von Anschlussleitungen. Dabei wird mittels einer Kamera ein Schaltschrankbild erstellt und der Bediener erstellt am Computer eine virtuelle Verkabelung. Eine Kabelkonfektionierungsmaschine schneidet dann die entsprechenden Kabel zu.

DE 195 12 840 A1 beschreibt ein Verfahren und eine Einrichtung für die Montage und Verdrahtung eines Schaltschrankes. Dabei werden durch zwei optische Zeigeeinheiten die zu verbindenden Komponenten im Schaltschrank markiert, um dem Arbeiter ein zeitaufwendiges Suchen zu ersparen. Ähnlich funktioniert die Einrichtung für den Zusammenbau und die Verdrahtung eines Schalt-/Verteilerschrankes gemäss DE 203 01 637 U1. Hierbei werden ebenfalls Zeigeeinrichtungen verwendet, um die Position des nächsten Bauteils das eingebaut werden soll zu markieren.

Die zuletzt beschriebenen Vorrichtungen haben die Nachteile, dass sie nur einen bestimmen Schritt des Verdrahtungsprozesses übernehmen und die Hauptlast der Arbeit immer noch beim Bediener liegt. Zusätzlich haben die beschriebenen Lösungen die Nachteile, dass die Konstruktion ihrer Greifer eine Verdrahtung von eng nebeneinander liegenden Anschlussstellen nicht zulässt oder beim Anschliessen ebensolcher die Gefahr besteht, dass schon vorhandene Verdrahtungen beschädigt oder gelöst werden.

Andererseits gibt es komplexe Roboter, welche eine komplette Verkabelung eines Schaltschrankes erledigen, jedoch auf Grund ihrer Komplexität Fehler anfällig sind und in Herstellung und Betrieb komplex sind (Averex, https://www.youtube.com/watch?v=Xg5ppssm00M).

DE 297 22 494 U1 zeigt einen Greifer, welcher einen Litzenanfang in einer Einsetzposition einsetzt. Anschliessend wird eine Litze verlegt, wobei ein Litzenende schlussendlich zu einer Litzenzufuhr zeigt, wenn es den Greifer erreicht. Der Greifer schwenkt das Litzenende in die Einsetzposition und schliesst das Litzenende an. Der Greifer ist hierbei so ausgebildet, dass sich eine Greiferschwenkachse mittig im Greifer befindet. Diese Konstruktion birgt den Nachteil, dass der Greifer breit ausgebildet ist, da der Rotationsmechanismus auf Höhe der Applikationsseite angebracht werden muss. Ein breiter Greifer kann zu Problemen führen, beim Verdrahten von eng nebeneinanderliegenden Anschlussstellen, da bestehende Verdrahtungen im Weg sind.

DE 443 12 54 A1 zeigt einen Greifer, welcher eine Litze verlegt, wobei ein Litzenanfang und ein Litzenende in einer Einsetzposition sich senkrecht zu einem Kabelpfad befinden. Der Greifer ist schmal ausgebildet und muss nicht zwingend rotieren, um das Litzenende anzuschliessen. Diese Bauweise birgt den Nachteil, dass ein Bauteil mit einer Anschlussstelle, welche sich senkrecht zu einer Montageplatte befindet, aus Platzgründen nicht oder nur erschwert angeschlossen werden kann.

Es ist daher Aufgabe der Erfindung, die Nachteile im Stand der Technik zu beheben. Insbesondere soll ein Verdrahtungsroboter bereitgestellt werden, welcher eine Verdrahtung von eng nebeneinander liegenden Anschlussstellen ermöglicht. Ausserdem soll ein Verdrahtungsroboter bereitgestellt werden, welcher einfach im Aufbau ist und zuverlässig arbeitet und ein Verdrahtungsroboter welcher eine Litze auf einfache Weise aufnehmen kann. Abschliessend soll ein Verfahren zur Verdrahtung mit den Verdrahtungsrobotern bereitgestellt werden.

Erfindungsgemäss werden diese und andere Aufgaben mit den Merkmalen gemäss der unabhängigen Patenansprüche gelöst.

Ein erfindungsgemässer Verdrahtungsroboter, insbesondere zum Verdrahten von Montageplatten und Montagerahmen, von Schaltschränken und Schaltgerätekombinationen oder Teilen davon umfasst einen Roboterkopf, eine Drahtzuführeinrichtung für eine zu verlegende Litze und einen Greifer zum Halten und/oder Applizieren der Litze. Die vorliegende Erfindung eignet sich zum Verlegen von Leitern aller Art. Sie wird nachstehend unter Bezugnahme auf Litzen erläutert, ohne dass dies als Beschränkung auf Litzen zu verstehen ist. Die Litze wird dabei von der Drahtzuführeinrichtung dem Greifer entlang eines Litzenpfades zugeführt. Der Greifer ist bewegbar im oder am Roboterkopf montiert und kann mindestens eine Einsetzposition und eine Umgreifposition einnehmen. Der Anfang einer zu verlegenden Litze wird in der Einsetzposition vom Greifer gehalten. Das Ende einer zu verlegenden Litze kann vom Greifer ergriffen werden, wenn dieser in der Umgreifposition ist. Der Litzenanfang und/oder das Litzenende sind an einer gewünschten Stelle applizierbar, wenn der Greifer sich in der Einsetzposition befindet. In der Einsetzposition ragt der Litzenanfang oder das Litzenende jeweils aus einer Applikationsseite des Greifers heraus beim Applizieren. Die Applikationsseite ist für den Litzenanfang und das Litzenende gleich.

Der Greifer ist bevorzugt schwenkbar um eine Greiferschwenkachse ausgebildet, insbesondere um eine Greiferschwenkachse, welche senkrecht zum Litzenpfad steht. Die Applikationsseite ist dabei bevorzugt von der Drahtzuführeinrichtung abgewandt, wenn sich der Greifer in der Einsetzposition befindet und der Drahtzuführeirichtung zugewandt, wenn sich der Greifer in der Umgreifposition befindet. Ein Vorteil einer solchen einfachen Bauweise ist, dass der Greifer schmal konstruiert werden kann.

Es ist aber auch denkbar, die Umgreifposition so zu positionieren, dass sie in Drahtzufuhrrichtung gesehen vor der Drahtzuführeinrichtung angeordnet ist. Damit lässt sich eine platzsparende Anordnung erzielen. Insbesondere lässt sich der Bauraum zwischen Drahtzuführeinrichtung und Greifer reduzieren. Zusätzlich wird die Litze von der Drahtzuführeinrichtung besser geführt, was zu einer höheren Wiederholgenauigkeit beim Umgreifen führt.

Der Greifer des erfindungsgemässen Verdrahtungsroboters rotiert bevorzugt um 180° um die Greiferschwenkachse, wenn er sich von der Umgreif- in die Einsetzposition oder umgekehrt bewegt.

Der Greifer des erfindungsgemässen Verdrahtungsroboters weist bevorzugt einen Greifer mit mindestens zwei Greifbacken auf, welche insbesondere ein winkliges Klemmprofil aufweisen. Das winklige Klemmprofil ermöglicht es, Litzen mit unterschiedlichen Durchmessern zu greifen. Das winklige Klemmprofil weist bevorzugt einen Winkel zwischen 60 und 120°, besonders bevorzugt zwischen 70 und 110° und ganz besonders bevorzugt zwischen 80 und 100° auf.

Die Drahtzuführeinrichtung ist bevorzugt so ausgebildet, dass die Litze in beide Richtungen transportiert werden kann, also zum Greifer hin oder von diesem weg entlang des Litzenpfades.

Bevorzugt hat der Verdrahtungsroboter einen Haltemechanismus, um eine Litze zu halten. Der Haltemechanismus wird bevorzugt durch eine Haltemechanismussteuerung gesteuert. Der Verdrahtungsroboter weist ebenfalls bevorzugt eine Greifersteuerung auf, um den Greifer zu steuern.

Die Haltemechanismussteuerung ist dabei bevorzugt so ausgebildet, dass der Haltemechanismus die Litze hält, wenn der Greifer geöffnet ist und die Litze nicht hält oder klemmt, wenn der Greifer geschlossen ist. Die Greifersteuerung ist so ausgebildet, dass sie den Greifer öffnet, bevor sich der Greifer von der Einsetz- in die Umgreifposition bewegt und dass sie den Greifer in der Umgreifposition wieder schliesst und geschlossen bleibt wenn der Greifer in die Einsetzposition zurück schwenkt. Die Zusammenarbeit des Haltemechanismus und der Greifersteuerung ermöglichen es dem Greifer die Litze umzugreifen, während die Litze durch den Haltemechanismus gehalten wird.

Der Haltemechanismus des erfindungsgemässen Verdrahtungsroboters weist bevorzugt Rollen zum Festhalten, Führen und Fördern des Kabels auf. Diese Rollen können in der Drahtzuführeinrichtung integriert sein. Die Rollen können eine Litze halten und fördern und bevorzugt in einem geöffneten Zustand die Litze freigeben.

Das Klemmprofil der Greifbacken des Greifers des erfindungsgemässen Verdrahtungsroboters weist bevorzugt eine Länge von 5.0 - 20.0 mm und besonders bevorzugt eine Länge von 7.0 - 12.0 mm auf. Das Klemmprofil kann Litzen mit einem Aussendurchmesser von 0.5 - 10 mm, bevorzugt mit einem Aussendurchmesser von 1 - 6 mm und besonders bevorzugt mit einem Aussendurchmesser von 2 - 4 mm klemmen. Alternativ oder ergänzend dazu weist die Applikationsseite des Greifers des erfindungsgemässen Verdrahtungsroboters eine bevorzugte Grundfläche von weniger als 50 mm², besonders bevorzugt weniger als 35 mm² und ganz besonders bevorzugt von weniger als 25 mm² auf. Eine Mantelfläche des Greifers befindet sich bevorzugt innerhalb eines gedachten Konus mit einem Winkel gegenüber einer Längsachse von 20°, bevorzugt 15° und besonders bevorzugt 10°. Durch den flachen Winkel der Mantelfläche und den geringen Durchmesser der Applikationsfläche erhält der Greifer eine schmale und spitze Form, welche es ihm ermöglicht, eng nebeneinander liegende Anschlussstellen zu verdrahten.

Alternativ ist es denkbar, dass der Verdrahtungsroboter mit einer vom Greifer unterschiedlichen Wendevorrichtung versehen ist. Die Wendevorrichtung ist dann bewegbar im Roboterkopf montiert. Die Wendevorrichtung ist mindestens zwischen einer Aufnahmeposition und einer Übergabeposition bewegbar. In der Aufnahmeposition ist das (hintere) Litzenende der zugeführten Litze mittels der Wendevorrichtung greifbar. In der Übergabeposition ist der Litzenanfang und/oder das Litzenende der zugeführten Litze von der Wendevorrichtung an den Greifer übergebbar. Durch die Aufteilung der Funktionen "Greifen" und "Wenden" in zwei unabhängige Einheiten lassen sich diese Einheiten je auf die jeweilige Funktion optimieren. Insbesondere lässt sich der Bauraum reduzieren, weil die Position der Klemmung und die Position des Wendens voneinander getrennt werden können.

Die Auftrennung von Wendefunktion und Greiffunktion erlaubt es auch, den Draht mittels der Wendevorrichtung um andere Wendewinkel als 180° zu wenden und anschliessend schräg in den Greifer einzusetzen. Damit lassen sich Drahtenden auch in schräg ausgerichtete Aufnahmen applizieren, ohne dass der Roboterkopf schräg gestellt werden muss. Dies kann insbesondere bei schwer zugänglichen Aufnahmen vorteilhaft sein.

Die Wendevorrichtung ist bevorzugt schwenkbar um eine Wendeachse ausgebildet. Die Wendeachse steht insbesondere senkrecht zum Litzenpfad.

Vorteilhaft können eine oder alle Greifbacke(n) mit einer Beschichtung versehen sein, welche eine erhöhte Reibung aufweist und/oder welche elastisch verformbar ist. Typischerweise können Beschichtungen aus (Natur)-Kautschuk aber auch aus Silikon, Chloropren oder anderen Elastomeren verwendet werden.

Beim Verwenden einer Elastomerbeschichtung kann auf ein Klemmprofil verzichtet werden. In diesem Fall ist eine ebene Greiffläche hinreichend. Durch die Deformation des Elastomers, verursacht durch den Anpressdruck der Litze, ergibt sich hier ein Profil.

Vorteilhaft ist der Verdrahtungsroboter so gestaltet, dass Litzen direkt und insbesondere durch eine Applikationsseite mit einem Greifer greifbar und mit einer Drahtzuführeinrichtung einziehbar sind. Der Greifer ist bevorzugt derart ausgebildet, dass er die Litze aus einer Lagereinheit oder einem anderen Behältnis oder von einer Fläche aufnehmen kann. Die Drahtzuführeinrichtung ist bevorzugt derart ausgebildet, dass sie die Litze vom Greifer übernimmt und diese einzieht. Eine komplizierte, externe Zuführung der Litze zum Greifer entfällt, da die Litze direkt aufgenommen und anschliessend verlegt wird. Eine Kombination mit den vorstehenden Aspekten ist denkbar aber nicht zwingend.

Ein weiterer Aspekt der Erfindung betrifft ein Verfahren zum Verdrahten von Montageplatten und Montagerahmen, von Schaltschränken und Schaltgerätekombinationen oder Teilen davon. Dabei wird ein Verdrahtungsroboter mit einem Greifer und einer Drahtzuführeinrichtung verwendet, insbesondere ein Verdrahtungsroboter wie vorstehend beschrieben. Dabei wird der Anfang einer Litze mit dem Greifer in eine erste Anschlussstelle eines ersten Bauteils eingesetzt. Der Greifer befindet sich beim Einsetzen in einer Einsetzposition. Die zu verlegende Litze wird mit dem Verdrahtungsroboter gemäss einem geplanten Litzenverlauf zu einer zweiten weiteren Anschlussstelle eines zweiten weiteren Bauteils verlegt. Selbstverständlich kann eine Litze auch zwischen zwei verschiedenen Anschlussstellen des gleichen Bauteils verlegt werden. Zum Anschliessen des Endes der Litze in die Anschlussstelle des zweiten Bauteils wird die Litze mit einem Haltemechanismus temporär gehalten. Der Greifer wird geöffnet und bewegt sich von der Einsetzposition in eine Umgreifposition, wobei eine Applikationsseite des Greifers nun zu einem Ende der Litze zeigt. Der Greifer wird danach geschlossen, um das Litzenende zu greifen. Anschliessend wird der Haltemechanismus geöffnet. Der Greifer schwenkt von der Umgreifposition in die Einsetzposition und verdrahtet mit dem hervorstehenden Litzenende die zweite Anschlussstelle des zweiten Bauteils. Das Litzenende kann während dem Umschwenken von der Umgreif- in die Einsetzposition aus dem Greifer herausragen. Falls dies nicht der Fall ist, wird das Litzenende vorgeschoben, bevor die Anschlussstelle verdrahtet wird, sodass das Litzenende aus der Applikationsseite des Greifers herausragt, wenn der Greifer in der Einsetzposition ist. Das Anbringen von Führungseinheiten zwischen den Greifbacken ermöglicht die sichere Verlegung bzw. Platzierung der Litzen in einen Kamm eines Kabelkanals und gewährleistet einen definierten Biegeradius der Litzen nach dem Wendevorgang.

Eine im Greifer integrierte Greifersteuerung ermöglicht ein automatisches Wechseln der Greifereinheit während des Prozesses. Es können so auch applikationsspezifische Versionen von Greifern für besonders anspruchsvolle Prozesse eingesetzt und im Verdrahtungsablauf gewechselt werden.

Die Erfindung wird nachstehend anhand von Ausführungsbeispielen und Zeichnungen zum besseren Verständnis erläutert.

Es zeigen:
- Fig. 1a:: Eine perspektivische Ansicht eines Greifers eines erfindungsgemässen Verdrahtungsroboters in einer Einsetzposition
- Fig. 1b:: Eine perspektivische Ansicht des Greifers des erfindungsgemässen Verdrahtungsroboters in einer Umgreifposition
- Fig. 1c:: Einen Seitenansicht des Greifers des erfindungsgemässen Verdrahtungsroboters mit vergrösserter Detailansicht
- Fig. 2a:: Einen Seitenansicht des Greifers mit einer Litze in einer Einsetzposition
- Fig. 2b:: Eine Seitenansicht des Greifers mit der Litze in einer Umgreifposition
- Fig. 2c:: Eine Seitenansicht des Greifers mit der Litze in der Einsetzposition
- Fig. 3a:: Eine Draufsicht auf den Greifer in der Einsetzposition und eine Drahtzuführeinrichtung
- Fig. 3b:: Eine Draufsicht auf den Greifer in der Umgreifposition und die Drahtzuführeinrichtung
- Fig. 3c:: Eine Seitenansicht des Greifers und der Litzenzuführeinrichtung
- Fig. 3d:: Eine Draufsicht auf den Greifer und die Litzenzuführeinrichtung
- Fig. 4a:: Eine perspektivische Ansicht durch die Greiferbacken
- Fig. 4b:: Eine perspektivische Ansicht und ein Querschnitt durch die Greiferbacken
- Fig. 4c:: Ein Querschnitt durch die Greiferbacken
- Fig. 5:: Eine schematische Darstellung eines Systems zum Planen von Verdrahtungen
- Fig. 6a:: Eine schematische Darstellung eines Systems zum Erfassen von Bauteilen
- Fig. 6b:: Eine perspektivische Ansicht eines Bauteils und eines Messkörpers
- Fig. 7a-d:: Eine schematische Darstellung eines Verdrahtungsvorgangs
- Fig. 8a-c: Eine schematische Darstellung der Bewegung von Greifarmen in einer Ausführungsform mit optimierter Führung
- Fig. 9: Eine schematische Darstellung einer alternativen Ausführungsform einer Greif- und Wendevorrichtung eines erfindungsgemässen Verdrahtungsroboters
- Fig. 10a-i: Sequentiell einzelne Positionen bei Verwendung der Ausführungsform gemäss Figur 9
- Fig. 11a-e: Sequentiell einzelne Positionen einer alternativen Verwendungsmöglichkeit der Ausführungsform gemäss Figur 9 mit schräg eingesetzter Litze und
- Fig. 12: Eine schematische Darstellung von Greifbacken mit einer Beschichtung.

Die Erfindung umfasst einen mehrachsigen und mehrgelenkigen Roboterarm eines Verdrahtungsroboters. An einem Ende des Verkabelungsroboters befindet sich ein Roboterkopf. Der Roboterkopf ist bevorzugt mit verschiedenen Werkzeugen wie Sensoreinheiten und einem Greifer ausgestattet. Mit diesen Werkzeugen kann der Verdrahtungsroboter Bauteile miteinander verdrahten.

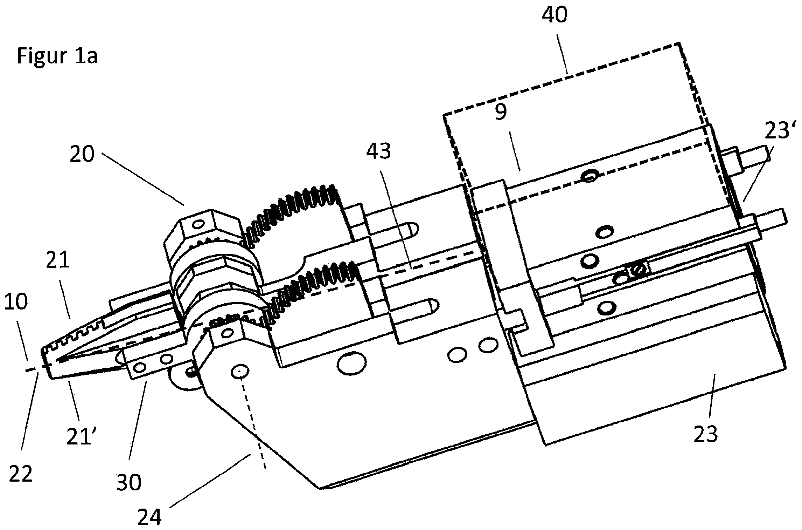

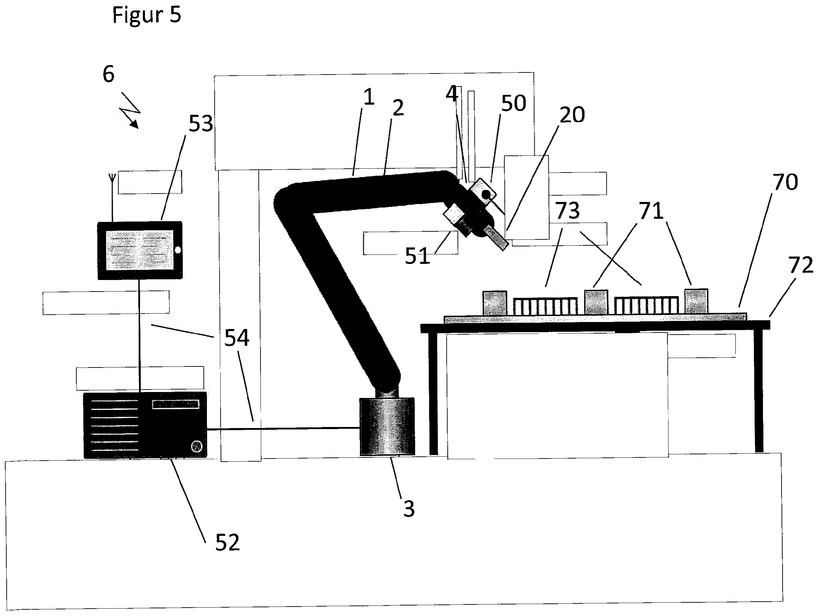

Figur 1a zeigt einen Greifer 20 eines erfindungsgemässen Verdrahtungsroboters 1 (dargestellt in Figur 5). Der Greifer 20 umfasst zwei Greifbacken 21, 21' mit einer Applikationsseite 22. Die beiden Greifbacken sind schwenkbar um eine Greiferschwenkachse 24 und werden einzeln vorzugsweise pneumatisch oder elektrisch angetrieben und positions- und / oder kraftgeregelt gesteuert mittels Drehbewegungs-Aktoren 23, 23'. Der Greifer in Figur 1a befindet sich in einer Einsetzposition 30. Ein Greifer-Aktor 9 öffnet und schliesst bzw. klemmt die Greiferbacken 21, 21`. Der Greifer-Aktor 9 ist ebenfalls vorzugsweise pneumatisch oder elektrisch angetrieben und positions- und / oder kraftgeregelt. Eine Drahtzuführeinrichtung 40 ist gestrichelt dargestellt. In der Einsetzposition 30 zeigt die Applikationsseite 22 von der Drahtzuführeinrichtung 40 weg. Von der Drahtzuführeinrichtung 40 führt eine Litze 10 durch den Greifer 20 zur Applikationsseite 22. Die Litze 10 ist gestrichelt dargestellt, um ihren Verlauf anzuzeigen. Die Litze 10 wird entlang eines Litzenpfades 43 geführt, welcher von der Drahtzuführeinrichtung 40 zum Greifer 20 führt.

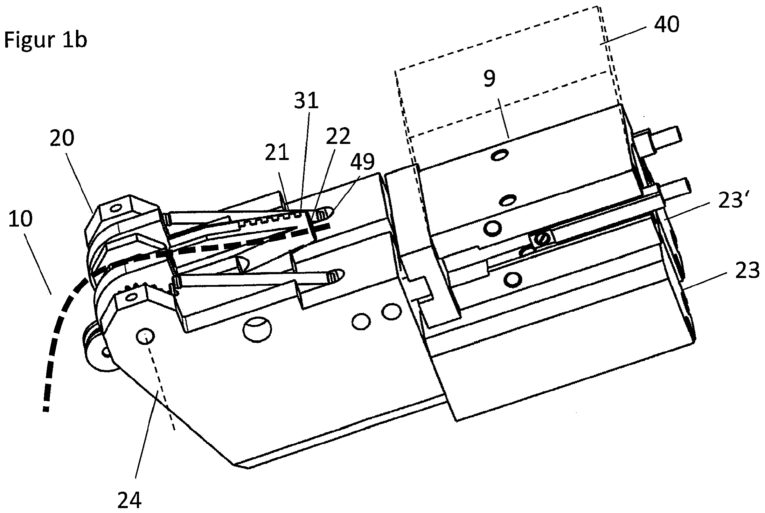

Figur 1b zeigt den Greifer 20 des erfindungsgemässen Verdrahtungsroboters 1 (dargestellt in Figur 5). Im Vergleich zu Figur 1a wurde der Greifer 20 um die Greiferschwenkachse 24 gewendet. Der Greifer 20 befindet sich in einer Umgreifposition 31, wobei die Applikationsseite 22 zur Drahtzuführeinrichtung 40 zeigt. Ein Litzenende 49 einer Litze 10 ragt aus der Applikationsseite 22 des Greifers 20 heraus.

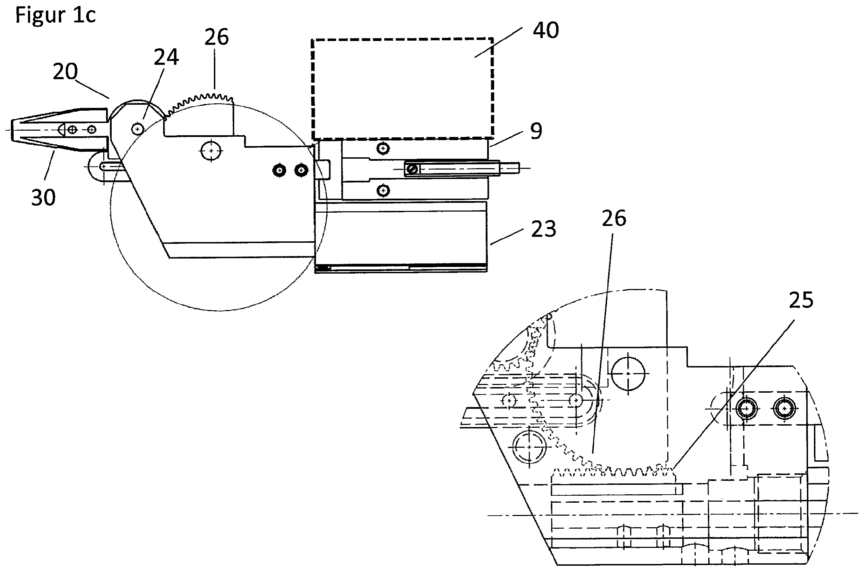

Figur 1c zeigt eine Seitenansicht des Greifers 20 des erfindungsgemässen Verdrahtungsroboters (dargestellt in Figur 5). Der Greifer befindet sich in der Einsetzposition 30. Mittels einer Zahnstange 25 und eines Zahnrades 26 kann der Greifer 20 um die Greiferschwenkachse 24 gedreht werden. Der Drehbewegungs-Aktor 23 zieht die Zahnstange 25 zurück, wobei das Zahnrad im Gegenuhrzeigersinn gedreht wird und der Greifer 20 im Uhrzeigersinn um die Greiferschwenkachse 24 von der Einsetzposition 30 in die Umgreifposition 31 schwenkt (siehe Figur 1b).

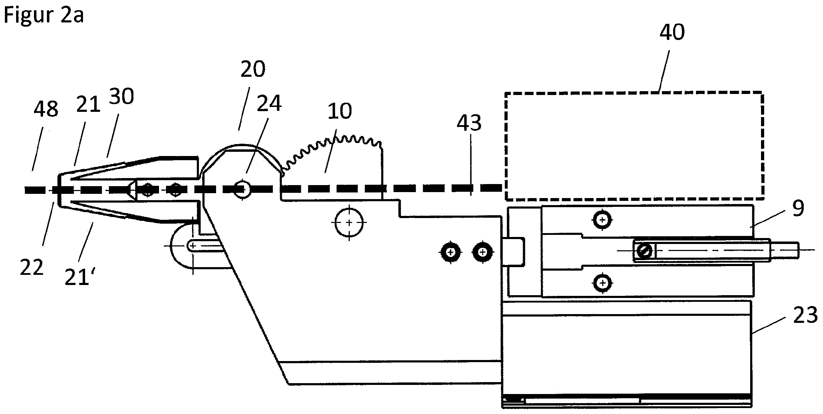

Figur 2a zeigt einen Längsschnitt durch den Greifer 20 in der Einsetzposition 30 mit einer Litze 10. Die Litze 10 umfasst ein Litzenanfang 48, welcher aus der Applikationsseite 22 des Greifers 20 herausragt. Die Litze 10 wird dabei dem Greifer 20 entlang eines Litzenpfades 43 von einer Drahtzuführeinheit 40 zugeführt. Die Litze 10 verläuft dabei durch die Greiferschwenkachse 24 zur Applikationsseite 22 des Greifers 20.

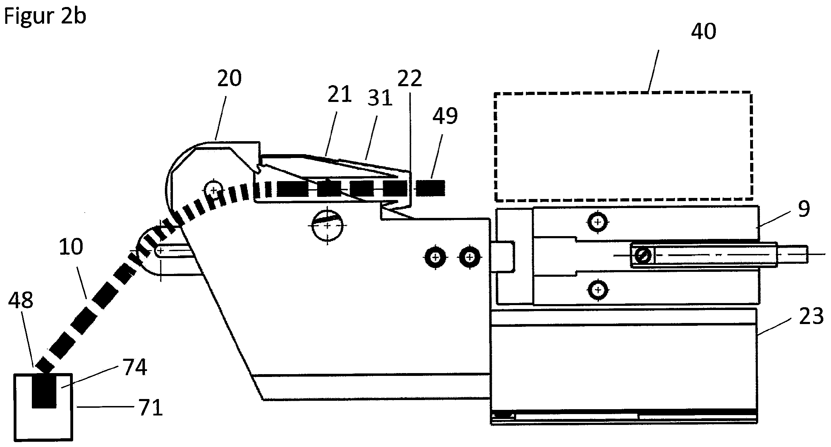

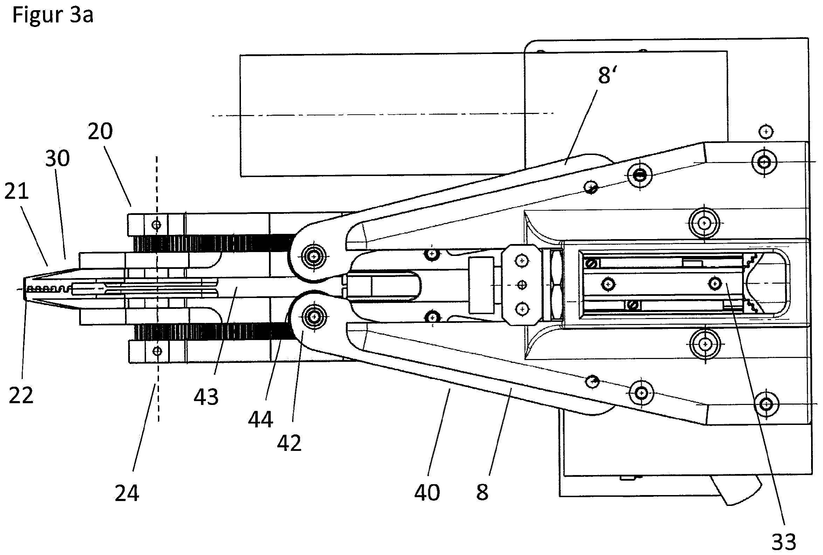

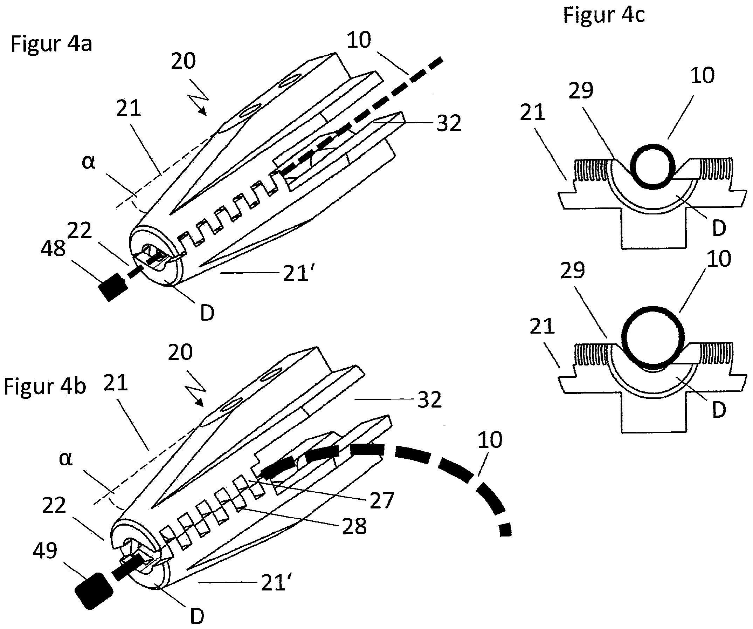

Figur 2b zeigt eine Seitenansicht des Greifers 20 in der Umgreifposition 31 mit der Litze 10. Beim Umgreifen wird erst die Litze 10 mit einem Haltemechanismus 42 (Figur 3a) geklemmt. Anschliessend öffnet sich der Greifer und schwenkt von der Einsetzposition 30 in die Umgreifposition 31, wo das Litzenende 49 wieder geklemmt wird. Das Litzenende 49 der Litze 10 ragt dabei nun aus der Applikationsseite 22 heraus und zeigt zur Drahtzuführeinheit 40. Der Kabelanfang 48 ist in einer Anschlussstelle 74 eines Bauteils 71 verbaut. Das gebogene Stück der Litze 10 wird dabei nach dem Herumschwenken in die Umgreifposition senkrecht zwischen den Greiferbacken 21, 21' durch eine Öffnung 32 (Figur 4) geführt.

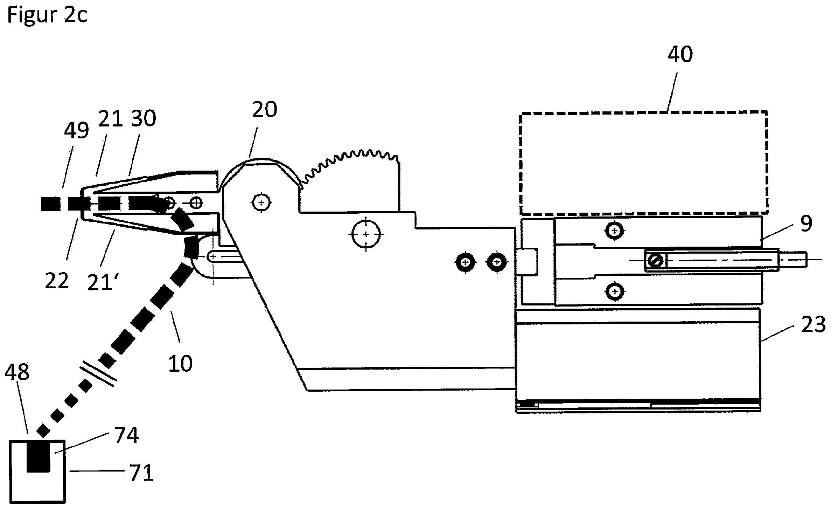

Figur 2c zeigt eine Seitenansicht des Greifers 20 in der Einsetzposition 30 mit einer Litze 10. Im Vergleich zu Figur 2b wurde der Greifer 20 um die Greiferschwenkachse 24 geschwenkt und das Litzenende 49 zeigt nun von der Drahtzuführeinheit 40 weg. Vor dem Schwenken des Greifers wurde der Haltemechanismus 42 (Figur 3a) gelöst, um die Litze 10 freizugeben. Das Litzenende 49, welches aus der Applikationsseite 22 des Greifers 20 herausragt, kann nun an eine Anschlussstelle eines weiteren Bauteils (nicht dargestellt) angeschlossen werden.

Figur 3a zeigt eine Draufsicht auf den Greifer 20 und die Drahtzuführeinrichtung 40. Die Greifbacken 21 sind in der Einsetzposition 30, wobei die Applikationsseite 22 von der Drahtzuführeinrichtung 40 weg zeigt. In der dargestellten Ausführungsform befindet sich ein Haltemechanismus 42 in Förderrichtung am Ende der Drahtzuführeinrichtung 40 und ist geschlossen. Der Haltemechanismus 42 umfasst einen Antrieb 33, Wippen 8 und 8` sowie Rollen 44, welche benutzt werden, um die Litze 10 (nicht dargestellt) zu fördern und wahlweise zu fixieren. Dabei klemmen die Rollen 44 die Litze 10 (nicht dargestellt), welche sich im Litzenpfad 43 befindet.

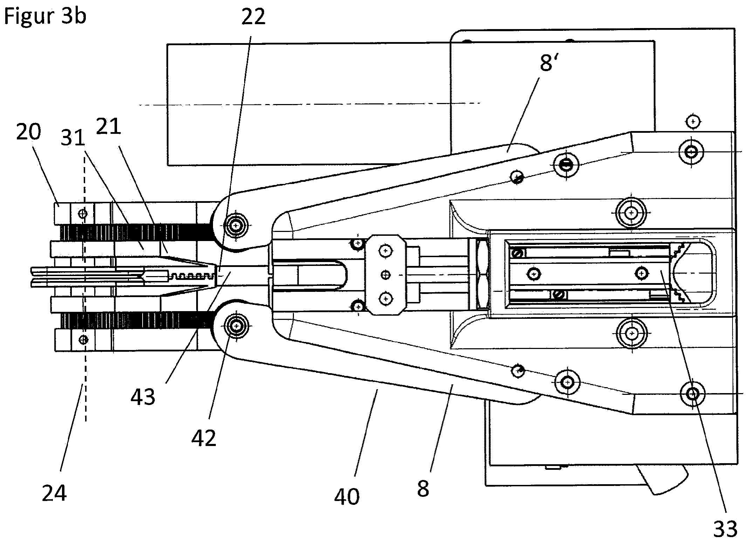

Figur 3b zeigt eine Draufsicht auf den Greifer 20 in der Umgreifposition 31 und die Drahtzuführeinrichtung 40 bevor der Greifer 20 wieder umschwenkt in die Einsetzposition 30 (Figur 3a). Der Haltemechanismus 42 an der Spitze der Drahtzuführeinrichtung 40 ist geöffnet und die Greiferbacken 21 sind geschlossen. In der Umgreifposition zeigt die Applikationsseite 22 zum Haltemechanismus 42.

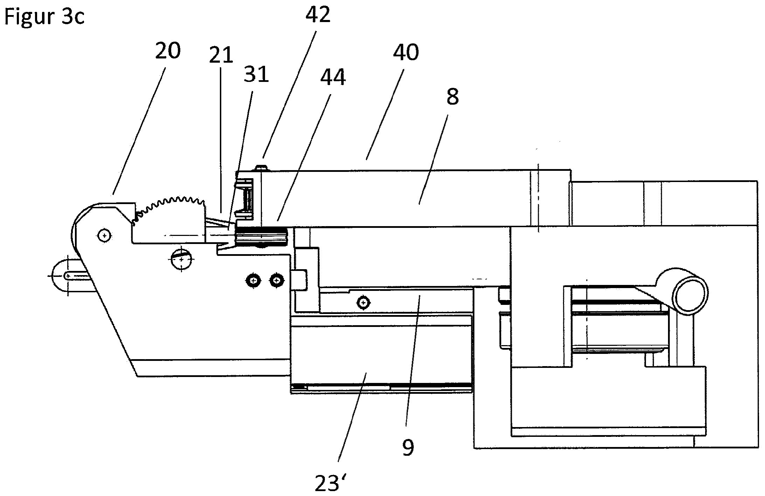

Figur 3c zeigt eine Seitenansicht des Greifers 20 und der Drahtzuführeinrichtung 40. Die Rollen 44 des Haltemechanismus 42 befinden sich zu beiden Seiten des Litzenpfades 43 (Figur 3b) in einer Ebene mit den Greifbacken 21 des Greifers 20 in der Umgreifposition 31.

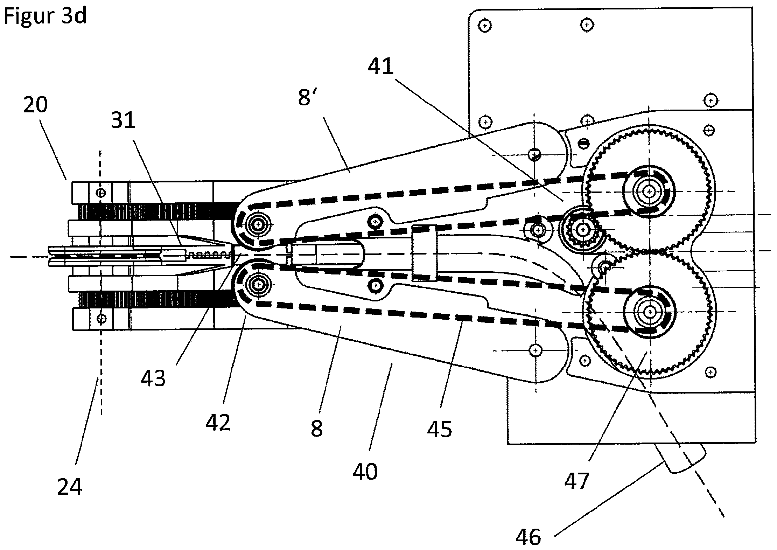

Figur 3d zeigt eine Draufsicht auf den Greifer 20 in der Umgreifposition 31 und die Drahtzuführeinrichtung 40. Die Litze (nicht dargestellt) wird dabei durch die Rollen 44 (Figur 3c) gefördert. Die Rollen 44 werden durch einen Riemen 45 mittels eines Zahnrades 47 und eines Antriebs 41 angetrieben. Die Kabellitze wird dabei über eine Zuführöffnung 46 in die Drahtzuführeinrichtung 40 eingeführt. Die Rollen 44 des Haltemechanismus 42 können mittels Antrieb 33 über die Wippen 8 und 8` geschlossen werden und somit eine Litze 10 (nicht dargestellt) halten bzw. in dieser geschlossenen Stellung in beide Richtungen fördern. Sind die Rollen 44 des Haltemechanismus 42 mit dem Antrieb 33 über die Wippen 8 und 8' geöffnet, kann ein Schwenken der beiden Greifbacken 21 von der Umgreifposition 31 zur Einsetzposition 30 mit eingesetzter Litze 10 erfolgen.

Figur 4a zeigt eine perspektivische Ansicht der Greiferbacken 21, 21`. Die Greiferbacken 21, 21` umschliessen die Litze 10. Die Litze 10 verläuft entlang einer Längsachse durch den Greifer 20, wobei der Litzenanfang 48 aus der Applikationsseite 22 herausragt. Das Litzenende 49 (Figur 4b) befindet sich noch in der Drahtzuführeinrichtung 40 (Figur 2a). Die Form des Greifers 20 wird durch eine Grundfläche D und einen Konuswinkel α definiert.

Figur 4b zeigt eine perspektivische Ansicht der Greiferbacken 21, 21`. Im Vergleich zu Figur 4a sind die Greiferbacken 21, 21' weiter voneinander entfernt und ermöglichen so, eine dickere Litze 10 zu umschliessen. Das Litzenende 49 der Litze 10 ragt aus der Applikationsseite 22 heraus. Die Litze 10 verläuft nicht wie in Figur 4a entlang einer Längsachse durch den Greifer 20, sondern wird seitlich durch eine Öffnung 32 aus dem Greifer 20 geführt, da der Litzenanfang 48 bereits angeschlossen wurde. Die Greiferbacken 21, 21' weisen Zähne 27 und Zahnlücken 28 auf, welche ineinander greifen.

Figur 4c zeigt einen Querschnitt durch eine Greiferbacke 21. Die Litze 10 liegt dabei in einem winkligen Profil 29. Das winklige Profil 29 kann wie dargestellt unterschiedlich dicke Litzen 10 umschliessen.

Figur 5 zeigt schematisch ein bevorzugtes und nicht beanspruchtes System zum Planen von Verdrahtungen 6. Eine Montageplatte bzw. ein Montagerahmen 70 mit Bauteilen 71 und Kabelkanälen 73 liegt auf einem Tisch 72. Ein Verdrahtungsroboter 1 ist auf einem Roboterfuss 3 befestigt. Ein Roboterarm 2 umfasst einen Roboterkopf 4 an der zum Roboterfuss 3 gegenüberliegenden Seite. Der Roboterkopf 4 umfasst eine Messeinheit 50, eine Kamera 51 und einen Greifer 20. Der Verdrahtungsroboter 1 ist über eine Datenleitung 54 mit einer Rechnereinheit 52 und einer Eingabevorrichtung 53 verbunden. Der Ablauf des Planens der Verdrahtung erfolgt wie folgt:
Der Verdrahtungsroboter 1 erfasst systematisch die Position und Lage der Montageplatte/des Montagerahmens 70 und seiner Bauteile 71. Diese Daten werden in der Rechnereinheit 52 mit den geplanten Konstruktionsdaten, welche vorzugsweise aus einem CAD System generiert werden, abgeglichen. Anschliessend werden die korrigierten Verdrahtungsinformationen von der Rechnereinheit 52 zum Verdrahtungsroboter 1 geschickt, woraufhin der Verdrahtungsroboter die Bauteile 71 miteinander verdrahtet.

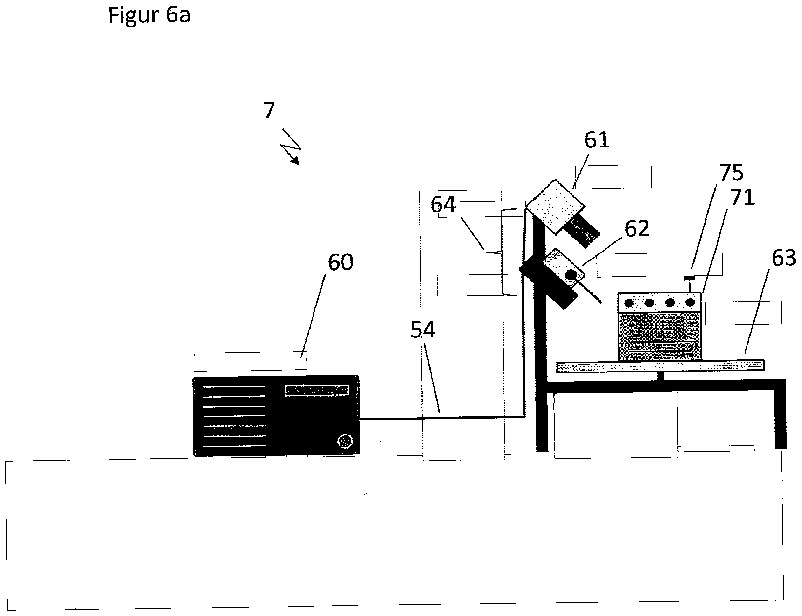

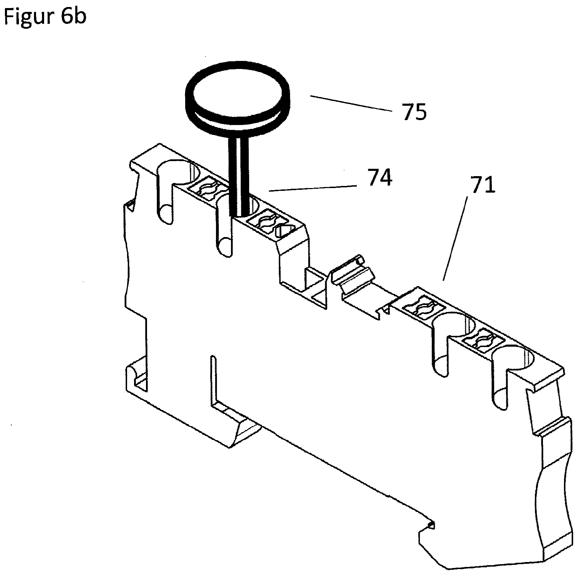

Figur 6a zeigt schematisch ein bevorzugtes und nicht beanspruchtes System zum Erfassen von Bauteilen 7 insbesondere zum Erfassen von elektrischen Bauteilen. Das System umfasst einen Drehtisch 63. Ein elektrisches Bauteil 71 wird auf dem Drehtisch 63 platziert. Eine Erfassungseinheit 64 umfasst eine Kamera 61 und einen Laser 62, welche das elektrische Bauteil 71 erfassen. Die Erfassungseinheit leitet die Daten über eine Datenleitung 54 zu einer Rechneranordnung 60. Die Erfassungseinheit 64 erfasst die Form des Bauteils 71 und die Position eines von Hand eingeführten Messkörpers 75, welcher sich in einer Anschlussstelle 74 (Figur 6b) befindet.

Zur Erfassung des Bauteils 71 wird mindestens eine volle Drehung des Drehtisches 63 vorgenommen.

Figur 6b zeigt eine perspektivische Ansicht des Bauteils 71 mit der Anschlussstelle 74 und dem Messkörper 75. Mittels des Messkörpers 75 werden die Position der Anschlussstelle 74 sowie die Tiefe und Richtung des Einschubkanals der Anschlussstelle vermessen.

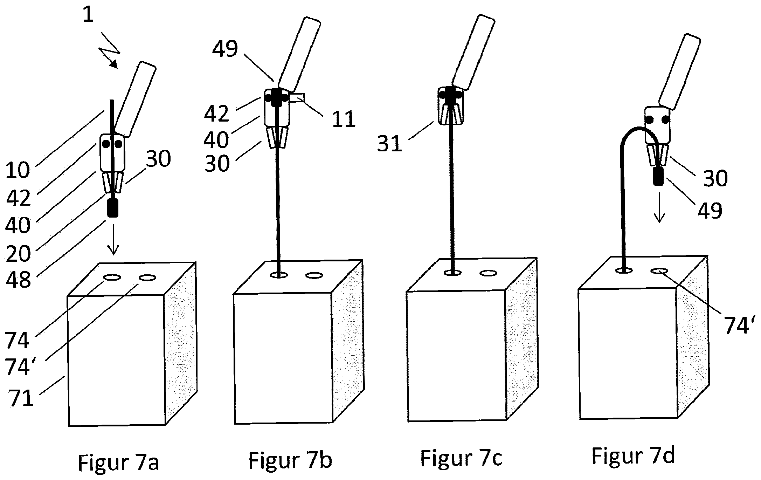

Figur 7a-d zeigt schematisch einen Verdrahtungsvorgang eines elektrischen Bauteils 71. Figur 7a zeigt ein elektrisches Bauteil 71 mit zwei Anschlussstellen 74, 74`. Ein Greifer 20 und eine Drahtzuführeinrichtung 40 bringen eine Litze 10 in Position, um einen Litzenanfang 48 in die Anschlussstelle 74 zu stecken. Nach erfolgtem Anschliessen kann wahlweise mittels einer Zugbewegung die Stabilität der Litze 10 in der Anschlussstelle 74 geprüft werden. Der Greifer 20 befindet sich in einer Einsetzposition 30 und ist geschlossen, während der Haltemechanismus 42 die Litze 10 klemmt. Nachdem der Litzenanfang 48 angeschlossen ist, verlegt der Verdrahtungsroboter 1 die Litze 10 gemäss einer geplanten Verdrahtung. Sobald ein Litzenende 49 in die Drahtzuführeinrichtung 40 eingezogen wird, klemmt der Haltemechanismus 42 das Litzenende 49 fest (Figur 7b). Das Litzenende 49 erzeugt einen Widerstand am Haltemechanismus 42, da es mit einer Endhülse mit Kragen ausgestattet ist, welche dicker ist die Litze 10 selbst. Alternativ kann das Litzenende 49 auch mit einem Fotosensor 11 erkannt werden, bevor es den Haltemechanismus 42 verlässt. Dies ist von Vorteil, wenn die Litze 10 keine Endhülse aufweist. Ergänzend kann die Litzenlänge der Litze 10 auch basierend auf der Umdrehung der Rollen 44 des Haltemechanismus 42 gemessen und überwacht werden. Sobald der Haltemechanismus 42 oder der Fotosensor 11 das Litzenende 49 erkennen, wird die Litze vorsorglich gestoppt. Der Greifer 20 kann gelöst werden (nicht dargestellt) und aus der Einsetzposition 30 in eine Umgreifposition 31 schwenken (Figur 7c). In der Umgreifposition 31 wird der Greifer 20 geschlossen und der Haltemechanismus 42 anschliessend geöffnet. Der Greifer 20 schwenkt zurück in die Einsetzposition 30 und kann nun das Litzenende 49 in die Anschlussstelle 74` einsetzen (Figur 7a).

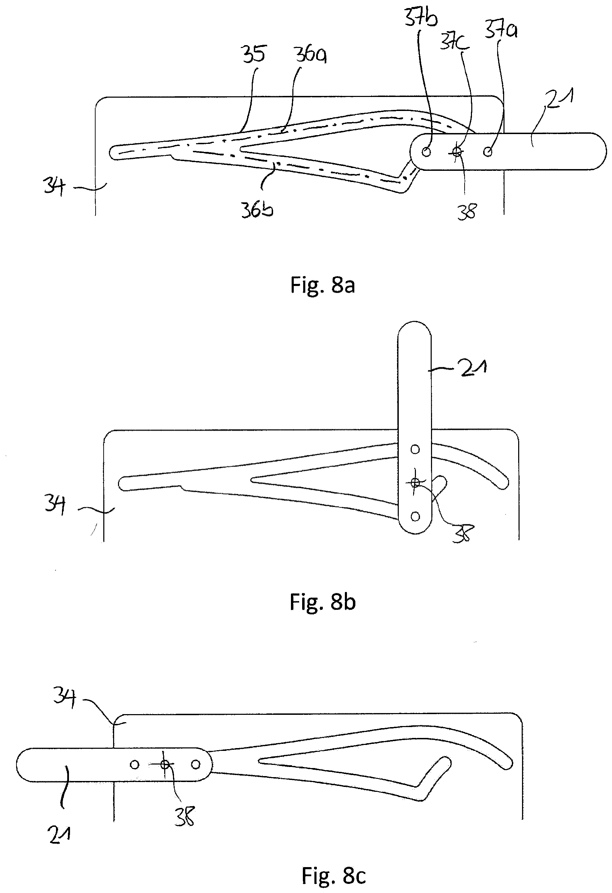

In den Figuren 8a bis 8c ist eine optimierte und nicht beanspruchte Führung zur Bewegung der Greiferbacken eines Greifers (schematisch) gezeigt. Die Führung ist durch zwei Platten gebildet, zwischen welchen der Greifer angeordnet ist und welche mit Führungskulissen versehen sind. In Figuren 8a bis 8c ist nur eine dieser Führungsplatten 34 gezeigt. Die Führungskulisse 35 weist eine untere und eine obere Führungsbahn 36a, 36b auf. Die Greiferbacke 21 ist mit zwei Bolzen 37a, 37b versehen, welche je in der oberen bzw. in der unteren Führungsbahn 36a, 36b verschiebbar gelagert sind. Es ist aber auch denkbar, nur die eine Führungsbahn 36b zu verwenden.

Figur 8a zeigt die Greiferbacke in einer Umgreifposition. Durch lineare Verschiebung des Greifarms (in Figur 8a von rechts nach links) bewegen sich die Bolzen 37a, 37b in den ihnen zugeordneten Führungsbahnen 36a, 36b. Dazu kann ein Antrieb in Längsrichtung am mittleren Bolzen 37c angreifen. Dadurch wird eine Schwenkbewegung der Greiferbacke 21 ausgelöst.

Figur 8b zeigt die Greiferbacke 21 in einer Zwischenposition und Figur 8c zeigt die Greiferbacke 21 in einer Applikationsposition.

Die Schwenkbewegung erfolgt dabei um einen Schwenkpunkt 38, der nicht fix ist, sondern sich im Lauf der Schwenkbewegung bewegt. Dadurch lässt sich der Bauraum verringern. Insbesondere bewegt sich der vorderste Teil der Greiferbacke 21 entlang einer gekrümmten Kurve, die in einer Richtung senkrecht zur Drahtzufuhrrichtung eine geringere Ausdehnung aufweist als der bei einer Rotation des Greifarms um einen fixen Drehpunkt von der Spitze des Greifarms beschriebenen Kreis.

Gleichzeitig lässt sich der axiale Abstand zwischen Applikationsposition und Umgreifposition erhöhen.

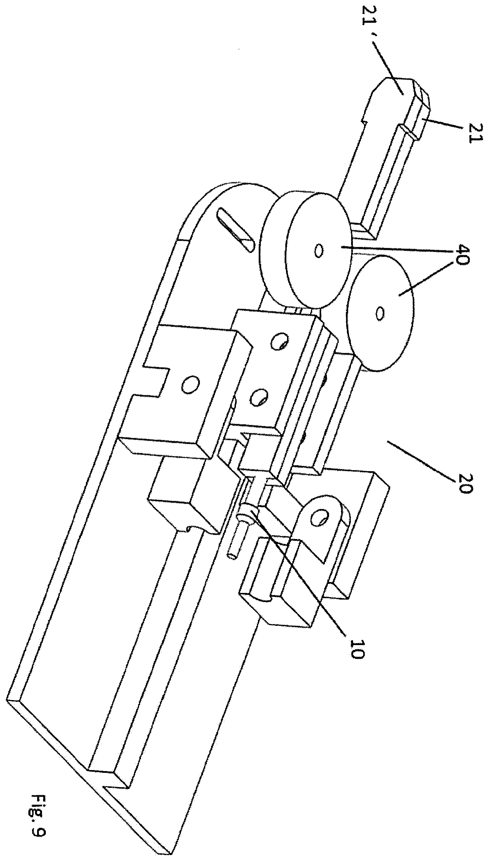

Figur 9 zeigt eine alternative Ausführungsform einer Greif- und Wendevorrichtung für einen erfindungsgemässen Verdrahtungsroboter. Anders als in den vorstehend beschriebenen Ausführungsformen ist bei dieser Ausführungsform der Greifmechanismus mit einem Greifer 20 von einer Wendevorrichtung 80 getrennt. Der Greifer 20 weist ähnlich wie in den vorstehend beschriebenen Ausführungsbeispielen zwei Greiferbacken 21, 21` auf. Anders als in diesen Ausführungsformen ist aber der Greifer 20 nur entlang einer Achsrichtung L linear verschiebbar und in einer Richtung Q quer dazu aufweitbar. Um ein Ende einer Litze 10 für eine korrekte Applikation in den Greifer 20 einzusetzen, ist die Vorrichtung ausserdem mit der separaten Wendevorrichtung 80 versehen. Die Wendevorrichtung 80 ist um eine Wendeachse 81 verschwenkbar. Sie weist Backen 82 auf, die in einer Richtung Q' quer zur Litzenzufuhrrichtung aufweitbar sind. Damit kann ein Litzenende in der in Figur 9 gezeigten Position von der Wendevorrichtung 80 ergriffen und durch Schwenken in den Bereich des in Achsrichtung L zurückgefahrenen Greifers 20 gebracht und an diesen übergeben werden.

Die Förderung der Litze, die Betätigung des Greifers 20 und die Betätigung der Wendevorrichtung 80 erfolgen auf ähnliche Art und Weise und mit ähnlichen Aktoren wie in der ersten Ausführungsform gemäss Figuren 1a bis 4c.

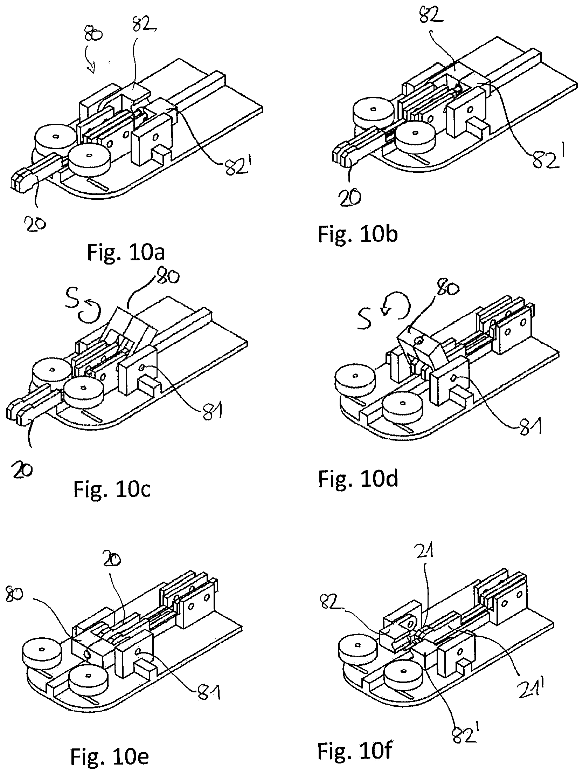

Figuren 10a bis 10i zeigen nacheinanderfolgend verschiedene Positionen, welche die Vorrichtung gemäss Figur 9 beim Wende- und Übergabevorgang einnimmt.

In Figur 10a ist eine Position gezeigt, in der die Litze 10 fast vollständig dem Greifer 20 zugeführt worden ist. Der Greifer 20 befindet sich in der Einsetzposition, in der die Litze applizierbar war. Das Ende der Litze 10 hat den Bereich der Wendevorrichtung 80 erreicht. Die Wendevorrichtung 80 ist in einer geöffneten Aufnahmeposition, sodass das Ende der Litze in den Bereich zwischen den zwei Backen 82, 82` der Wendevorrichtung positionierbar ist.

In Figur 10b sind die Backen 82, 82` der Wendevorrichtung 80 lateral gegeneinander verschoben, sodass das Litzenende zwischen den Backen 82, 82` der Wendevorrichtung eingeklemmt wird.

In Figuren 10c und 10d ist gezeigt, wie die Wendevorrichtung 80 in Schwenkrichtung S um 180° um die Wendeachse 81 in eine Übergabeposition verschwenkt wird. Gleichzeitig wird der Greifer 20 mittels eines Schlittens, auf dem er gelagert ist, entgegen der Längsrichtung L linear verschoben. Damit bewegt sich der Greifer 20 axial gegen die Wendevorrichtung 80 hin. Die Greiferbacken 21, 21c des Greifers 20 sind in dieser Konfiguration lateral geöffnet, sodass sich der im Bereich des Greifers 20 vorhandene Abschnitt der Litze 10 aus dem Greifer 20 entfernen lässt.

Die Bewegung von Wendevorrichtung und Litze ist koordiniert, sodass in der in Figur 10e dargestellten Position die Wendevorrichtung um 180° gewendet und unmittelbar vor dem vorderen Ende des Greifers 20 zu liegen kommt. Am Schluss der Verschwenkbewegung der Wendevorrichtung 80 mit eingesetztem Litzenende und axialer Verschiebung des Greifers 20 wird das Litzenende so zwischen die geöffneten Greiferbacken 21, 21' positioniert, dass ein kurzer Abschnitt des Litzenendes aus der Applikationsseite des Greifers 20 vorsteht.

In der in Figur 10f gezeichneten Konfiguration sind die Greiferbacken 21, 21' gegeneinander hin zugestellt und ergreifen klemmend die Litze, während die Backen 82, 82' der Wendevorrichtung 80 lateral geöffnet werden und ihrerseits das Litzenende freigeben.

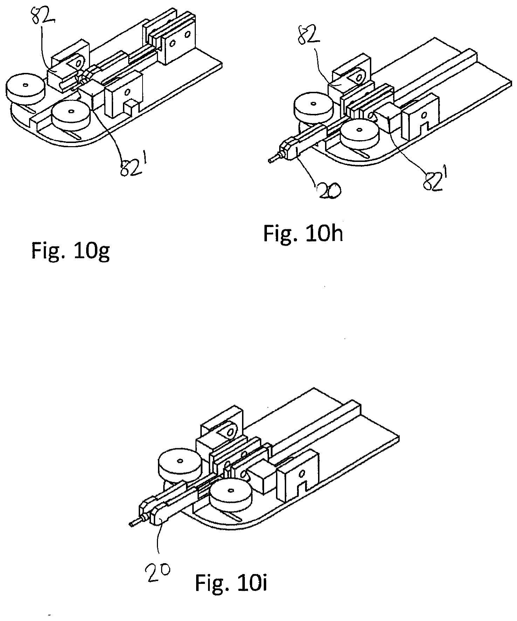

Figur 10g zeigt, wie die Backen 82, 82'lateral möglichst weit geöffnet sind, sodass der Greifer 20 linear in Richtung L bewegt werden kann (siehe Figur 10g und 10h). In der in Figur 10h gezeigten Position bewegt sich der Greifer 20 weiter nach vorne, bis er die in Figur 10i gezeigte, finale Position erreicht, in der das Litzenende appliziert werden kann.

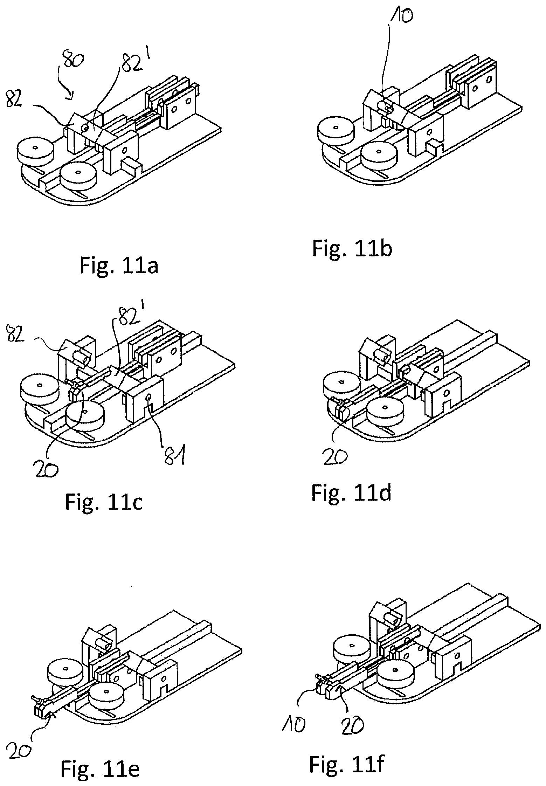

Bei einer alternativen Anwendung ist es auch denkbar, mittels der Wendevorrichtung 80 das Litzenende um einen Winkelbetrag von weniger als 180° zu verschwenken. Die Schwenkbewegung wird dann in der in Figur 11a gezeigten Position beendet. In dieser Position sind die Backen 82, 82' um ca. 120° verschwenkt und es kann das Litzenende an den Greifer 20 übergeben werden (siehe Figur 11b) .

Durch laterales Öffnen der Backen 82, 82` der Wendevorrichtung 80 wird das Litzenende freigegeben und bezogen auf die Längsrichtung L im Greifer 20 schräg unter einem Winkel angeordnet (siehe Figur 11c). Der Greifer 20 kann anschliessend wie in den Figuren 11d und 11e gezeigt axial nach vorne (in den Figuren von rechts nach links) verschoben werden, sodass das Ende der Litze 10 wie in Figur 11f gezeigt unter einem Winkel appliziert werden kann.

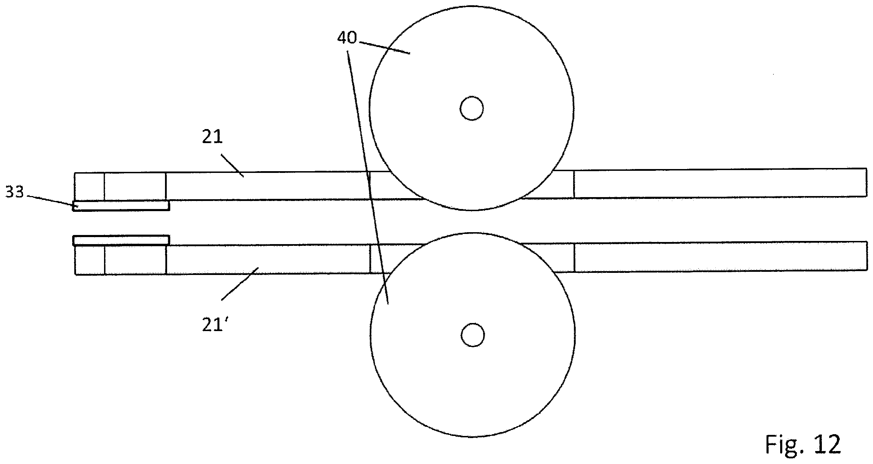

Figur 12 zeigt schliesslich eine schematische Darstellung von Greiferbacken 21, 21' mit einer Beschichtung 33. Die Greiferbacken 21, 21' sind als metallische Werkstücke ausgebildet. Die Beschichtung 33 ist durch (Natur)-kautschuk (oder anderen Elastomerwerkstoffen) ausgebildet, der beispielsweise mittels Kleben auf den Greiferbacken 21, 21` befestigt ist. Andere Befestigungen beispielsweise mittels Schrauben oder Klemmen sind denkbar. In der Ausführungsform gemäss Figur 12 sind die Beschichtungen 33 auf beiden Greiferbacken 21, 21` angebracht und flächig auf den Greiferbacken 21, 21`aufgetragen. Es versteht sich von selbst, dass auch Lösungen denkbar sind, bei denen nur eine Greiferbacke beschichtet ist oder Lösungen, bei denen die Greiferbacken zwei Auflageflächen für eine Beschichtung aufweisen, wobei ein Zwischenraum zwischen den Auflageflächen gebildet ist. Durch diesen Zwischenraum lässt sich eine zusätzliche Verformbarkeit und Anpresskraft erzielen, wenn die Beschichtung beim Zustellen der Greifbacken durch die eingeklemmte Litze in den Zwischenraum gedrückt wird.

## Patentansprüche

1. Verdrahtungsroboter (1), insbesondere zum Verdrahten von Montageplatten und Montagerahmen, von Schaltschränken und Schaltgerätekombinationen oder Teilen davon, umfassend einen Roboterkopf (4), eine Drahtzuführeinrichtung (40) für eine zu verlegende Litze (10) und einen Greifer (20) zum Halten und Applizieren der Litze (10), wobei die Litze (10) mittels der Drahtzuführeinrichtung (40) dem Greifer (20) entlang eines Litzenpfads (43) zuführbar ist, wobei der Greifer (20) bewegbar im Roboterkopf (4) montiert **dadurch gekennzeichnet, dass** der Greifer (20) mindestens zwischen einer Einsetzposition (30) und einer Umgreifposition (31) bewegbar ist, wobei ein Litzenende (49) der zugeführten Litze (10) in der Umgreifposition (31) mittels des Greifers (20) greifbar ist und der Litzenanfang (48) und/oder das Litzenende (49) der zugeführten Litze (10) in der Einsetzposition (30) mittels des Greifers (20) applizierbar ist und beim Applizieren ein Litzenanfang (48) oder ein Litzenende (49) in der Einsetzposition (30) des Greifers (20) aus einer Applikationsseite (22) des Greifers (20) herausragt.

2. Verdrahtungsroboter (1) gemäss Anspruch 1, **dadurch gekennzeichnet, dass** der Greifer (20) schwenkbar um eine Greiferschwenkachse (24) ausgebildet ist, insbesondere um eine Greiferschwenkachse (24), welche senkrecht zum Litzenpfad (43) steht.

3. Verdrahtungsroboter (1) gemäss einem der Ansprüche 1 oder 2, **dadurch gekennzeichnet, dass** in der Umgreifposition (31) die Applikationsseite (22) des Greifers (20) zur Drahtzuführeinrichtung (40) zeigt und in der Einsetzposition (30) die Applikationsseite (22) des Greifers (20) von der Drahtzuführeinrichtung (40) weg zeigt.

4. Verdrahtungsroboter (1) gemäss einem der Ansprüche 1 bis 3, **dadurch gekennzeichnet, dass** der Greifer (20) mindestens zwei Greifbacken (21) aufweist, welche insbesondere je ein winkliges Klemmprofil (29) aufweisen und wobei das winklige Klemmprofil (29) bevorzugt einen Winkel von 60 - 120°, besonders bevorzug einen Winkel von 70 - 110° und ganz besonders bevorzugt einen Winkel von 80 - 100° aufweist.

5. Verdrahtungsroboter (1) gemäss einem der Ansprüche 1 bis 4, **dadurch gekennzeichnet, dass** der Verdrahtungsroboter (1) einen Haltemechanismus (42) zum Fixieren einer Litze (10) aufweist, der mit einer Haltemechanismussteuerung gesteuert wird und eine Greifersteuerung, welche den Greifer (20) steuerbar macht.

6. Verdrahtungsroboter (1) gemäss Anspruch 5, **dadurch gekennzeichnet, dass** die Haltemechanismussteuerung so ausgebildet ist, dass die Litze (10) gehalten wird, während der Greifer (20) geöffnet ist und die Greifersteuerung so ausgebildet ist, dass der Greifer (20) geöffnet ist, während der Greifer (20) von der Einsetz- in die Umgreifposition (30,31) schwenkt.

7. Verdrahtungsroboter gemäss einem der Ansprüche 5 oder 6, **dadurch gekennzeichnet, dass** die Haltemechanismussteuerung so ausgebildet ist, dass die Litze (10) nicht gehalten wird, wenn der Greifer (20) in der Umgreifposition (31) geschlossen ist und dass die Greifersteuerung so ausgebildet ist, dass der Greifer (20) geschlossen ist, während der Greifer (20) von der Umgreif- in die Einsetzposition (31,30) schwenkt.

8. Verdrahtungsroboter (1) gemäss einem der Ansprüche 4 bis 7, **dadurch gekennzeichnet, dass** das Klemmprofil (29) der Greifbacke (21) des Greifers (20) eine Länge (L) von 5.0 - 20.0 mm, bevorzugt eine Länge (L) von 7.0 - 12.0 mm aufweist und/oder die Applikationsseite (22) eine Grundfläche (D) von weniger als 50 mm², bevorzugt weniger als 35 mm² und besonders bevorzugt von weniger als 25 mm² aufweist und der Greifer (20) eine Mantelfläche umfasst, welche sich in einen gedachten Konus befindet mit einem Konuswinkel (α) von 20°, bevorzugt 15° und besonders bevorzugt 10° gegenüber einer Längsachse.

9. Verdrahtungsroboter (1) gemäss einem der Ansprüche 1 oder 4 bis 6, wobei der Verdrahtungsroboter mit einer vom Greifer unterschiedlichen Wendevorrichtung (80) versehen ist, welche bewegbar im Roboterkopf (4) montiert ist, wobei die Wendevorrichtung (80) mindestens zwischen einer Aufnahmeposition und einer Übergabeposition bewegbar ist, wobei das Litzenende der zugeführten Litze (10) in der Aufnahmeposition mittels der Wendevorrichtung (80) greifbar ist, der Litzenanfang und/oder das Litzenende der zugeführten Litze (10) in der Übergabeposition mittels der Wendevorrichtung (80) an den Greifer übergebbar ist.

10. Verdrahtungsroboter (1) gemäss Anspruch 9, wobei die Wendevorrichtung (80) schwenkbar um eine Wendeachse (81) ausgebildet ist, insbesondere um eine Wendeachse (81), welche senkrecht zum Litzenpfad (43) steht.

11. Verdrahtungsroboter (1) gemäss Anspruch 9 oder 10, wobei die Litze (10) in der Übergabeposition parallel zum Litzenpfad liegt oder unter einem Winkel zum Litzenpfad liegt.

12. Verdrahtungsroboter (1) gemäss einem der Ansprüche 4 bis 11, wobei wenigsten eine Greiferbacke (21, 21')mit einer Beschichtung (33) versehen ist, welche eine erhöhte Reibung aufweist und/oder welche elastisch verformbar ist, insbesondere eine Beschichtung aus Elastomeren, insbesondere (Natur)-kautschuk, Silikon, Chloropren.

13. Verdrahtungsroboter (1) gemäss einem der Ansprüche 1 bis 12, **dadurch gekennzeichnet, dass** die Litze (10) insbesondere durch eine Applikationsseite (22) hindurch, mit dem Greifer (20) aufnehmbar und mit einer Drahtzuführeinrichtung (40) einziehbar ist.

14. Verfahren zum Verdrahten von Montageplatten und Montagerahmen, von Schaltschränken und Schaltgerätekombinationen oder Teilen davon, unter Verwendung eines Verdrahtungsroboters (1) mit einem Greifer (20) und einer Drahtzuführeinrichtung (40), insbesondere nach einem der Ansprüche 1 bis 13, umfassend die folgenden Schritte:
- Einsetzen eines Anfangs einer Litze (10) in einer ersten Anschlussstelle (74) eines ersten elektrischen Bauteils (71) ;
- Führen der Litze (10) gemäss eines geplanten Drahtverlaufs zu einer zweiten Anschlussstelle (74`), insbesondere in einem zweiten Bauteil (71');
- Klemmen der Litze (10) mit einem Haltemechanismus (42);
- Öffnen des Greifers (20);
- Umschwenken des Greifers (20) in eine Umgreifposition (31), so dass eine Applikationsseite (22) des Greifers (20) zu einem Litzenende (49) zeigt;
- Schliessen des Greifers (20) und anschliessend Öffnen des Haltemechanismus (42);
- Wenden des Greifers (20) von der Umgreifposition (31) in die Einsetzposition (30);
- Einsetzen des Litzenendes (49) in die zweite Anschlussstelle (74`) .

## Claims

1. Wiring robot (1), in particular for wiring mounting plates and mounting frames, switch cabinets and switchgear combinations or parts thereof, comprising a robot head (4), a wire feed device (40) for a strand to be laid and a gripper (20) for holding and applying the strand (10), wherein the strand (10) can be fed to the gripper (20) along a strand path (43) by means of the wire feed device (40), wherein
the gripper (20) is movably mounted in the robot head (4), **characterized in that** the gripper (20) is movable at least between an insertion position (30) and a gripping position (31), wherein a strand beginning (48) and/or the strand end (49) of the supplied strand (10) can be gripped in the gripping position (31) by means of the gripper (20) and the strand beginning (48) and/or the strand end (49) of the supplied strand (10) in the insertion position (30) by means of the gripper (20), and a strand beginning (48) or a strand end (49) in the insertion position (30) of the gripper (20) projects out of an application side (22) of the gripper (20) during application.

2. Wiring robot (1) according to claim 1, **characterized in that** the gripper (20) is designed to be pivotable about a gripper pivot axis (24), in particular about a gripper pivot axis (24) which is perpendicular to the strand path (43) .

3. Wiring robot (1) according to one of claims 1 or 2, **characterized in that** in the gripping position (31) the application side (22) of the gripper (20) points towards the wire feed device (40) and in the insertion position (30) the application side (22) of the gripper (20) points away from the wire feed device (40).

4. Wiring robot (1) according to any one of claims 1 to 3, **characterized in that** the gripper (20) has at least two gripper jaws (21), which in particular each have an angled clamping profile (29) and wherein the angled clamping profile (29) preferably has an angle of 60 - 120°, particularly preferably an angle of 70 - 110° and very particularly preferably an angle of 80 - 100°.

5. A wiring robot (1) according to any one of claims 1 to 4, **characterized in that** the wiring robot (1) comprises a holding mechanism (42) for fixing a strand (10), which is controlled with a holding mechanism control, and a gripper control which makes the gripper (20) controllable.

6. A wiring robot (1) according to claim 5, **characterized in that** the holding mechanism control is configured to hold the strand (10) while the gripper (20) is open and the gripper control is configured to open the gripper (20) while the gripper (20) pivots from the inserting position to the gripping position (30,31).

7. A wiring robot according to any one of claims 5 or 6, **characterized in that** the holding mechanism control is configured such that the strand (10) is not held when the gripper (20) is closed in the gripping position (31) and that the gripper control is configured such that the gripper (20) is closed while the gripper (20) pivots from the gripping to the insertion position (31,30).

8. Wiring robot (1) according to one of claims 4 to 7, **characterized in that** the clamping profile (29) of the gripper jaw (21) of the gripper (20) has a length (L) of 5.0 - 20.0 mm, preferably a length (L) of 7.0 - 12.0 mm, preferably a length (L) of 7.0 - 12.0 mm, and/or the application side (22) has a base area (D) of less than 50 mm² , preferably less than 35 mm² and particularly preferably less than 25 mm² and the gripper (20) comprises a lateral surface which is located in an imaginary cone with a cone angle (α) of 20°, preferably 15° and particularly preferably 10° relative to a longitudinal axis.

9. Wiring robot (1) according to one of claims 1 or 4 to 6, wherein the wiring robot is provided with a turning device (80) different from the gripper, which is movably mounted in the robot head (4), wherein the turning device (80) is movable at least between a receiving position and a transfer position wherein the strand beginning and/or the strand end of the supplied strand (10) can be gripped in the receiving position by means of the turning device (80), the strand beginning and/or the strand end of the supplied strand (10) can be transferred to the gripper in the transfer position by means of the turning device (80).

10. Wiring robot (1) according to claim 9, wherein the turning device (80) is designed to be pivotable about a turning axis (81), in particular about a turning axis (81) which is perpendicular to the strand path (43).

11. Wiring robot (1) according to claim 9 or 10, wherein the strand (10) in the transfer position is parallel to the strand path or is at an angle to the strand path.

12. Wiring robot (1) according to one of claims 4 to 11, wherein at least one gripper jaw (21, 21') is provided with a coating (33) which has increased friction and/or which is elastically deformable, in particular a coating of elastomers, in particular (natural) rubber, silicone, chloroprene.

13. Wiring robot (1) according to one of claims 1 to 12, **characterized in that** the strand (10) can be picked up by the gripper (20), in particular through an application side (22), and can be drawn in by a wire feed device (40).

14. Method for wiring mounting plates and mounting frames, switch cabinets and switch cabinet combinations or parts thereof, using a wiring robot (1) with a gripper (20) and a wire feed device (40), in particular according to one of claims 1 to 13, comprising the following steps:
- Inserting a beginning of a strand (10) into a first connection point (74) of a first electrical component (71) ;
- Guiding the strand (10) according to a planned wire run to a second connection point (74'), in particular in a second component (71');
- Clamping the strand (10) with a holding mechanism (42);
- Open the gripper (20);
- Swiveling the gripper (20) into a gripping position (31) so that an application side (22) of the gripper (20) faces a strand end (49);
- Closing the gripper (20) and then opening the holding mechanism (42);
- Turning the gripper (20) from the gripping position (31) to the insertion position (30);
- Insert the strand end (49) into the second connection point (74').

## Revendications

1. Robot de câblage (1), en particulier pour le câblage de plaques de montage et de cadres de montage, d'armoires de distribution et de combinaisons d'appareillage de commutation ou de parties de celles-ci, comprenant une tête de robot (4), un dispositif d'alimentation en fil (40) pour un brin à poser et un préhenseur (20) pour tenir et appliquer le brin (10),
dans lequel le brin (10) peut être amené au préhenseur (20) le long d'un chemin du brin (43) au moyen du dispositif d'alimentation en fil (40), et dans lequel
le préhenseur (20) est monté mobile dans la tête du robot (4), **caractérisé en ce que** le préhenseur (20) est mobile au moins entre une position d'insertion (30) et une position de préhension (31), dans laquelle un début du brin (48) et/ou l'extrémité du brin (49) du brin fourni (10) peut être saisi dans la position de préhension (31) au moyen du préhenseur (20) et le début du brin (48) et/ou l'extrémité du brin (49) du brin fourni (10) dans la position d'insertion (30) au moyen du préhenseur (20), et un début du brin (48) ou une extrémité du brin (49) dans la position d'insertion (30) du préhenseur (20) dépasse d'un côté d'application (22) du préhenseur (20) pendant l'application.

2. Robot de câblage (1) selon la revendication 1, **caractérisé en ce que** le préhenseur (20) est conçu pour pouvoir pivoter autour d'un axe de pivotement du préhenseur (24), notamment autour d'un axe de pivotement du préhenseur (24) qui est perpendiculaire au chemin du brin (43).

3. Robot de câblage (1) selon l'une des revendications 1 ou 2, **caractérisé en ce que**, dans la position de préhension (31), le côté application (22) du préhenseur (20) est orienté vers le dispositif d'alimentation filaire (40) et, dans la position d'insertion (30), le côté application (22) du préhenseur (20) est orienté à l'opposé du dispositif d'alimentation filaire (40).

4. Robot de câblage (1) selon l'une quelconque des revendications 1 à 3, **caractérisé en ce que** le préhenseur (20) comporte au moins deux mâchoires de préhension (21), qui présentent notamment chacune un profil de serrage angulaire (29) et dans lequel le profil de serrage angulaire (29) présente de préférence un angle de 60 à 120°, de manière particulièrement préférée un angle de 70 à 110° et de manière très particulièrement préférée un angle de 80 à 100°.

5. Robot de câblage (1) selon l'une quelconque des revendications 1 à 4, **caractérisé en ce que** le robot de câblage (1) comprend un mécanisme de retenue (42) pour la fixation d'un brin (10), qui est commandé avec une commande du mécanisme de retenue, et une commande du préhenseur qui rend le préhenseur (20) contrôlable.

6. Robot de câblage (1) selon la revendication 5, **caractérisé en ce que** la commande du mécanisme de retenue est configurée pour retenir le brin (10) pendant que le préhenseur (20) est ouvert et **en ce que** la commande du préhenseur est configurée pour ouvrir le préhenseur (20) pendant que le préhenseur (20) pivote de la position d'insertion à la position de préhension (30,31).

7. Robot de câblage selon l'une quelconque des revendications 5 ou 6, **caractérisé en ce que** la commande du mécanisme de retenue est configurée pour que le brin (10) ne soit pas retenu lorsque le préhenseur (20) est fermé dans la position de préhension (31) et **en ce que** la commande du préhenseur est configurée pour que le préhenseur (20) soit fermé pendant que le préhenseur (20) pivote de la position de préhension à la position d'insertion (31,30).

8. Robot de câblage (1) selon l'une des revendications 4 à 7, **caractérisé en ce que** le profil de serrage (29) de la mâchoire de préhenseur (21) du préhenseur (20) a une longueur (L) de 5,0 à 20,0 mm, de préférence une longueur (L) de 7,0 à 12,0 mm, de préférence une longueur (L) de 7,0 à 12.0 mm, et/ou le côté d'application (22) a une surface de base (D) inférieure à 50 mm² , de préférence inférieure à 35 mm² et de manière particulièrement préférée inférieure à 25 mm² et le préhenseur (20) comprend une surface latérale qui est située dans un cône imaginaire avec un angle de cône (α) de 20°, de préférence de 15° et de manière particulièrement préférée de 10° par rapport à un axe longitudinal.

9. Robot de câblage (1) selon l'une des revendications 1 ou 4 à 6, dans lequel le robot de câblage est pourvu d'un dispositif de rotation (80) différent du préhenseur, qui est monté mobile dans la tête du robot (4), dans lequel le dispositif de rotation (80) est mobile au moins entre une position de réception et une position de transfert, dans laquelle le début du brin et/ou l'extrémité du brin fourni (10) peut être saisi dans la position de réception au moyen du dispositif de rotation (80), le début du brin et/ou l'extrémité du brin fourni (10) peut être transféré vers le préhenseur dans la position de transfert.

10. Robot de câblage (1) selon la revendication 9, dans lequel le dispositif de rotation (80) est conçu pour pouvoir pivoter autour d'un axe de rotation (81), en particulier autour d'un axe de rotation (81) qui est perpendiculaire au chemin du brin (43).

11. Robot de câblage (1) selon la revendication 9 ou 10, dans lequel le brin (10) dans la position de transfert est parallèle au chemin du brin ou forme un angle avec le chemin du brin.

12. Robot de câblage (1) selon l'une des revendications 4 à 11, dans lequel au moins une mâchoire de préhenseur (21, 21') est pourvue d'un revêtement (33) présentant un frottement accru et/ou élastiquement déformable, notamment un revêtement en élastomères, en particulier en caoutchouc (naturel), en silicone, en chloroprène.

13. Robot de câblage (1) selon l'une des revendications 1 à 12, **caractérisé en ce que** le brin (10) peut être saisi par le préhenseur (20), notamment par un côté d'application (22), et peut être entraîné par un dispositif d'alimentation en fil (40).

14. Procédé de câblage de plaques de montage et de cadres de montage, d'armoires de commande et de combinaisons d'armoires de commande ou de leurs parties, à l'aide d'un robot de câblage (1) muni d'un préhenseur (20) et d'un dispositif d'alimentation en fil (40), notamment selon l'une des revendications 1 à 13, comprenant les étapes suivantes :
- Insertion d'un début du brin (10) dans un premier point de connexion (74) d'un premier composant électrique (71);
- Guider le brin (10) selon un parcours de fils planifié jusqu'à un deuxième point de connexion (74'), en particulier dans un deuxième composant (71');
- Serrer le brin (10) à l'aide d'un mécanisme de retenue (42) ;
- Ouvrir le préhenseur (20);
- Faire pivoter le préhenseur (20) dans une position de préhension (31) de sorte qu'un côté d'application (22) du préhenseur (20) soit en face d'une extrémité du brin (49) ;
- Fermeture du préhenseur (20) puis ouverture du mécanisme de retenue (42);
- Tourner le préhenseur (20) de la position de préhension (31) à la position d'insertion (30);
- Insérer l'extrémité du brin (49) dans le deuxième point de connexion (74').
